# EUROPEAN PATENT APPLICATION

(11) **EP 4 790 610 A1**
(43) Date of publication of application: **12.08.2026**
(21) Application number: 26154334.2
(22) Date of filing: 27.01.2026
(51) Int. Cl.: G06Q 10/06, G06Q 10/087, G06Q 50/04

(54) **AEROSPACE ASSEMBLY REVISION MANAGEMENT USING A PRODUCT LIFECYCLE MANAGEMENT SYSTEM**

(30) Priority: 11.02.2025 US 202519050585
(71) Applicant: General Electric Company, Cincinnati, Ohio 45215 (US)
(72) Inventor: RANGASWAMY, Shyam, West Chester, 45069 (US); DOGUPARTHI, Ramyasree, 560066 Bengaluru (IN); KOMMURU, Subbu, West Chester, 45069 (US); NAMBURI, Kedar, West Chester, 45069 (US)
(74) Representative: Openshaw & Co.

(57) **Abstract**

A method for generating a live engineering bill of materials (EBOM) (200) in a project lifecycle management (PLM) system (10) is provided. The method includes generating a lifecycle status (208) for each part of one or more parts of a product. The method further includes generating, with a bill of materials (BOM) generation module, the live EBOM (200) based on product data (116) and the lifecycle status (208). The live EBOM (200) includes a table (202) having at least one line (204) representing each part of the one or more parts in the product. Each line (204) of the at least one line (204) includes the lifecycle status (208) and at least one of the part name data (118), part ID data (120), or part quantity data (122).

## Description

### FIELD

The present disclosure relates to aerospace assembly revision management using a production lifecycle management (PLM) system.

### BACKGROUND

Product lifecycle management (PLM) systems have been developed as a resource to provide a global environment for developing, describing, managing and communicating digital product knowledge and related information. Some PLM systems enable a company to design and render products virtually, thus avoiding the need to build prototypes. Such systems can save money, parts and other resources as well improve product and workplace safety and ergonomics.

PLM systems may generate and manage an engineering bill of materials (EBOM) for a product, which refers to a listing a listing of all parts in the product. Traditionally, revising the product in the PLM system results in the existing EBOM being saved as history and an entirely new EBOM being generated that reflects the revision to the product. This causes large scale data duplication and prevents historical data from being viewed on the new EBOM.

Accordingly, an improved method for generation and revision management of an EBOM in a PLM system is desired and would be appreciated in the art.

### BRIEF DESCRIPTION OF THE DRAWINGS

A full and enabling disclosure of the present disclosure, including the best mode thereof, directed to one of ordinary skill in the art, is set forth in the specification, which makes reference to the appended figures, in which:
FIG. 1 is a block diagram of a computing system in accordance with embodiments of the present disclosure;
FIG. 2 is a schematic diagram of a PLM system in accordance with embodiments of the present disclosure;
FIG. 3 illustrates a schematic diagram of a PLM system in accordance with embodiments of the present disclosure;
FIG. 4 is a block diagram of an EBOM system, which may be included in the PLM system shown in FIG. 2, in accordance with various aspects of the present disclosure;
FIGS. 5A, 5B, 5C illustrate a live EBOM in various stages, e.g., in an original form, after a first change, and after a second change, in accordance with embodiments of the present disclosure;
FIGS. 6A and 6B illustrate a live EBOM before and after being organized based on one or more lifecycle statuses, in accordance with various aspects of the present disclosure;
FIGS. 7A and 7B illustrate a live EBOM before and after being organized based on one or more lifecycle statuses, in accordance with various aspects of the present disclosure;
FIGS. 8A and 8B illustrate a live EBOM before and after being organized based on one or more lifecycle statuses, in accordance with various aspects of the present disclosure;
FIGS. 9A and 9B illustrate a live EBOM before and after being organized based on one or more lifecycle statuses, in accordance with various aspects of the present disclosure; and
FIG. 10 is a flow diagram of a method for generating an EBOM in a PLM system in accordance with embodiments of the present disclosure.

### DETAILED DESCRIPTION

Reference will now be made in detail to present embodiments of the disclosure, one or more examples of which are illustrated in the accompanying drawings. The detailed description uses numerical and letter designations to refer to features in the drawings. Like or similar designations in the drawings and description have been used to refer to like or similar parts of the disclosure.

The word "exemplary" is used herein to mean "serving as an example, instance, or illustration." Any implementation described herein as "exemplary" is not necessarily to be construed as preferred or advantageous over other implementations. Additionally, unless specifically identified otherwise, all embodiments described herein should be considered exemplary.

The singular forms "a", "an", and "the" include plural references unless the context clearly dictates otherwise.

The term "at least one of" in the context of, e.g., "at least one of A, B, and C" refers to only A, only B, only C, or any combination of A, B, and C.

Traditionally, PLM systems adopt a "revision" based approach when engineering changes impact an EBOM. Every change creates an entirely new EBOM, and the old EBOM is saved as history. The new EBOM typically differs from the old EBOM only in the line items that were impacted by the change that caused the revision. This is not an efficient method because it results in large scale data duplications. For example, traditionally, the old EBOM and the new EBOM are both saved in the PLM system and each include all entries with the only difference being the line items that were impacted by the change.

The present disclosure is generally related to generation and revision management of a live EBOM using a PLM system. The live EBOM may be a single, continuous, bill of materials that includes all historical data and current data for a product from the PLM system. For example, when a revision (or change) is made to one or more parts in the product using the PLM system, the live EBOM may be updated to include the change while maintaining the historical data. This advantageously prevents the creation of a new EBOM every time a revision is made, which drastically reduces data production and thereby reduces data storage costs. Additionally, the live EBOM allows for all changes to the product to be viewed on a single EBOM.

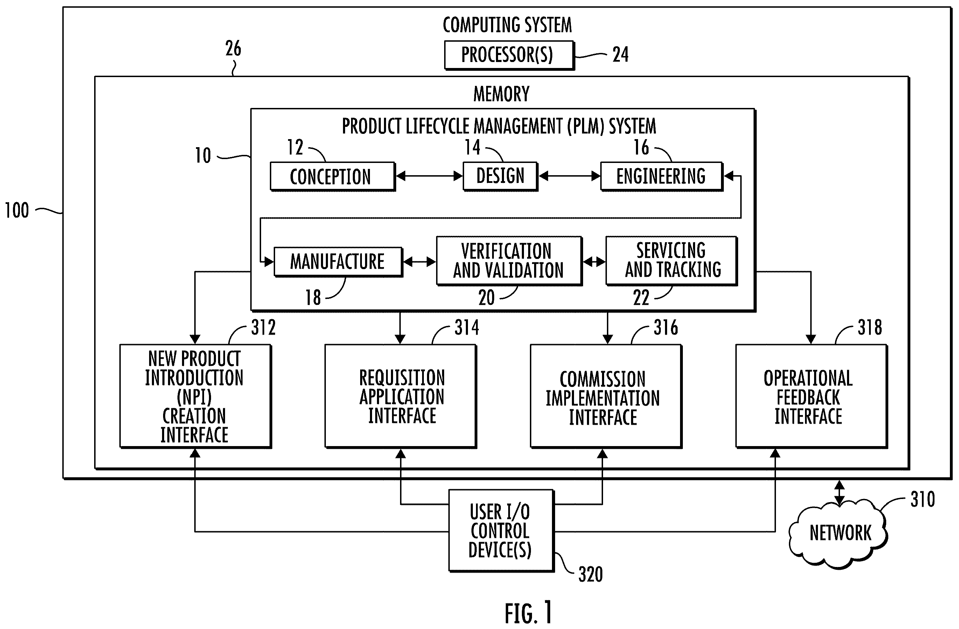

Referring now to the drawings, wherein identical numerals indicate the same elements throughout the figures, FIG. 1 illustrates a block diagram of a computing system 100, which includes one or more processor(s) 24 and a memory 26. The memory 26 may store an embodiment of a product lifecycle management (PLM) system 10, including particular software modules within the PLM system and user interface features for accessing the PLM system according to the present disclosure.

Specifically, FIG. 1 illustrates an embodiment of a PLM system 10 suitable for providing for a variety of processes, including PLM processes 12, 14, 16, 18, 20, 22. In the depicted embodiment, the PLM system 10 may include support for execution of conception processes 12. For example, the conception processes 12 may produce a set of specifications such as requirements specifications documenting a set of requirements to be satisfied by a design, a part, a product, or a combination thereof. The conception processes 12 may also produce a concept or prototype for the part or product (e.g., machine). A series of design processes 14 may then use the specifications and/or prototype to produce, for example, one or more three-dimensional (3D) design models of the part or product, which may include utilizing a computer aided design (CAD) system. The 3D design models may include solid/surface modeling, parametric models, wireframe models, vector models, non-uniform rational basis spline (NURBS) models, geometric models, 2D manufacturing part and assembly drawings, and the like.

Design models may then be further refined and added to via the execution of development/engineering processes 16. The development/engineering processes may, for example, create and apply models such as thermodynamic models, low cycle fatigue (LCF) models, life prediction models, multibody dynamics (MBD) and kinematics models, computational fluid dynamics (CFD) models, finite element analysis (FEA) models, and/or 3-dimension to 2-dimension FEA mapping models that may be used to predict the behavior of the part or product during its operation. For example, turbine blades may be modeled to predict fluid flows, pressures, clearances, and the like, during operations of a gas turbine engine. The development/engineering processes 16 may additionally result in tolerances, materials specifications (e.g., material type, material hardness), clearance specifications, and the like. For example, an aerospace component (such as a turbine or compressor blade) may be modeled during the development/engineering process using one or more of the models mentioned above. The FEA models may be utilized for analyzing thermal stresses mechanical loads, and/or vibrations experienced by the aerospace component during operation. The CFD models may be utilized for simulating fluid flow, heat transfer, and/or aerodynamics associated with the aerospace component. The LCF models may be utilized for predicting the fatigue life of the aerospace component, which may be subject to cyclic loading during operation of the aerospace engine.

The PLM system 10 may additionally provide for manufacturing processes 18 that may include manufacturing automation support. For example, additive manufacturing models may be derived, such as 3D printing models for material jetting, binder jetting, vat photopolymerization, powder bed fusion, sheet lamination, directed energy deposition, material extrusion, and the like, to create the part or product. Other manufacturing models may be derived, such as computer numeric control (CNC) models with G-code to machine or otherwise remove material to produce the part or product (e.g., via milling, lathing, plasma cutting, wire cutting, and so on). Requisition orders, purchasing orders, and the like, may also be provided as part of the manufacturing processes 18 (or other PLM processes).

The PLM system 10 may additionally provide for verification and/or validation processes 20 that may include automated inspection of the part or product as well as automated comparison of specifications, requirements, and the like.

A servicing and tracking set of processes 22 may also be provided via the PLM system 10. The servicing and tracking processes 22 may log maintenance activities for the part, part replacements, part life (e.g., in fired hours), and so on. As illustrated, the PLM system 10 may include feedback between the processes 12, 14, 16, 18, 20, 22. For example, data from services and tracking processes 22, for example, may be used to redesign the part or product via the design processes 14. Indeed, data from any one of the processes 12, 14, 16, 18, 20, 22 may be used by any other of the processes 12, 14, 16, 18, 20, 22 to improve the part or product or to create a new part or a new product. In this manner, the PLM system 10 may incorporate data from downstream processes and use the data to improve the part or to create a new part.

As one non-limiting example, an aerospace product may be generated and/or managed by the PLM system 10. During the conception process 12, the PLM system 10 may be provided or may generate one or more requirements or targets of the aerospace product (such as weight, thrust, durability targets). For example, requirements or targets may include structural strength (e.g., part must withstand a certain load), aerodynamics (e.g., drag coefficient must not exceed a certain threshold), weight, materials, or other requirements. Additionally, during the conception process 12, the materials may be identified that meet the one or more requirements or targets and initial computational simulations may be performed. During the design process 14 and engineering process 16, the computer aided design (CAD) tools of the PLM system 10 may be utilized for modeling the aerospace product and testing the aerospace product. For example, a CAD model of the aerospace product may be generated using the PLM system 10, and the CAD model may be utilized for performing simulations (such as FEA simulations, CFD simulations, or other simulations) to confirm the aerospace product meets design requirements. For example, if the aerospace product is a turbine blade, the FEA simulations or CFD simulations may determine whether the turbine blade can perform as intended and withstand the stresses associated with operation. Additionally, during the engineering process 16, the PLM system 10 may generate an EBOM for the aerospace product, which may include a structured list or table of all components and materials associated with the aerospace product. The PLM system 10 may generate the EBOM by extracting data from the CAD model associated with the aerospace product, such as part names, part numbers, part materials, structure of the aerospace product, material data, or other data. For example, in implementations where the aerospace product is a turbine blade assembly, the EBOM may include a structured list or table of each component, including materials, part name, part number, etc. Specifically, in such implementations, the list or table may include: airfoil (ceramic material, part number 001, etc.), root (titanium material, part number 002, etc.), shroud (steel, part number 003, etc.).

During the manufacturing process 18, the additive manufacturing models, CNC models, or other models associated with the production of the components/assemblies of the aerospace product be generated based on the CAD model of the aerospace product. Additionally, work instructions (e.g., for machinists and/or assemblers) associated with the aerospace product may be generated using the PLM system 10. The work instructions may include a list of steps that outline or describe how to assemble the aerospace product. The EBOM and the work instructions may be utilized for generating a manufacturing bill of materials (MBOM). The MBOM may include the work instructions that describe how the aerospace product will be assembled, machined, and built. The work instructions may include assembly or machining sequencing (e.g., machine part A, additively manufacture part B, connect part A to part B to form assembly C, etc.). For example, in implementations in which the aerospace product is a turbine blade assembly, the MBOM may include: machining the airfoil, additively manufacturing the root, welding the root to the airfoil, etc.

As should be appreciated, when a change is made to the aerospace product during the design or engineering process 14, 16, this impacts the EBOM, which then impacts the MBOM. For example, if a change is made to a geometry, material, or design of the CAD model associated with the aerospace product in the PLM system 10 (for example, the airfoil of the turbine blade assembly), then this may impact how the aerospace product (e.g., the turbine blade assembly) is represented on the EBOM (e.g., in the form of material updates, structure updates, part name updates, part number updates, or others). Subsequently, the work instructions on the MBOM may be updated according to the changes on the EBOM. For example, the additive manufacturing or machining instructions may be updated on the MBOM based on the design/material changes made to the CAD model, or the assembly instructions may be made based on structure updates to the CAD model.

Additionally, during the manufacturing process 18, the MBOM may be utilized by the PLM system 10 for generating a bill of process (BOP), which may define a manufacturing workflow needed to transform raw materials into a final product. The BOP may link the MBOM to tools, machines, or other physical workstations that are needed to fabricate the aerospace product. For example, in implementations where the aerospace product is a turbine blade assembly, the BOP may include, e.g., utilizing CNC to fabricate airfoil from titanium, utilizing additive manufacturing system to generate root from ceramic powder, welding the airfoil to the root at welding station, etc.

The computing system 100 may include the one or more processor(s) 24 and a memory 26 (which may store the PLM system 10) that may execute software programs to perform the disclosed techniques. Moreover, the processors 24 may include multiple microprocessors, one or more "general-purpose" microprocessors, one or more special-purpose microprocessors, and/or one or more application specific integrated circuits (ASICS), or some combination thereof. For example, the processors 24 may include one or more reduced instruction set (RISC) processors. The PLM system 10 is a software-based system having a set of computer-readable and executable instructions that are stored on a tangible computer-readable medium such as represented by the memory 26. The memory 26 may include the software instructions configured to implement the program features and steps of PLM system 10 and/or product data and other information that is accessed by the software instructions. Memory 26 may be provided as single or multiple portions of one or more varieties of tangible, non-transitory computer-readable media, such as but not limited to any combination of volatile memory (e.g., random access memory (RAM, such as DRAM, SRAM, etc.) and nonvolatile memory (e.g., ROM, flash, hard drives, magnetic tapes, CD-ROM, DVD-ROM, etc.) or any other memory devices including diskettes, drives, other magnetic-based storage media, optical storage media, solid state storage media and others.

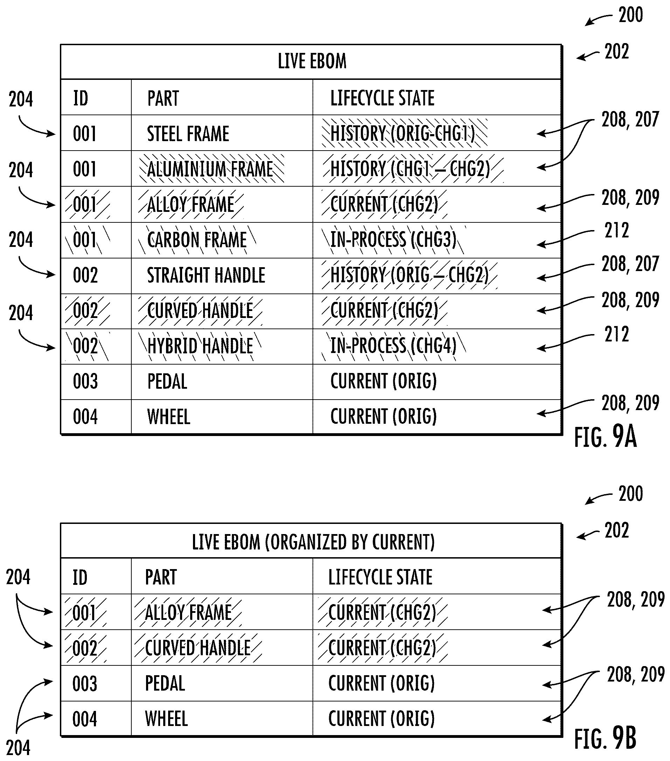

The memory 26 may include one or more non-transitory computer-readable media that collectively store instructions that, when executed by the one or more processors 24, cause the computing system 100 to perform operations, such as the operations described below with reference to FIG. 9.

The PLM system 10 may be stored in a variety of computer-accessible media locations, for example on one or more dedicated servers or combinations of networked computers or networked storage devices. In some embodiments, the storage location of PLM system 10 is accessible from other computing systems via network 310. In some embodiments, other computing systems (not shown) connected to the network 310 locally store a copy of PLM system 10, but selected data accessed by such application is stored in a central or distributed network-accessible location.

When access to the software features of PLM system 10 is obtained remotely, such remote connection may be established directly or indirectly via one or more wired or wireless connections to the memory/media device 26 hosting the PLM system 10. Remote computers may be coupled via network 310, which may correspond to any type of network, including but not limited to a dial-in network, a utility network, public switched telephone network (PSTN), a local area network (LAN), wide area network (WAN), local area network (LAN), wide area network (WAN), metropolitan area network (MAN), personal area network (PAN), virtual private network (VPN), campus area network (CAN), storage area network (SAN), the Internet, intranet or Ethernet type networks, combinations of two or more of these types of networks or others, implemented with any variety of network topologies in a combination of one or more wired and/or wireless communication links.

Computing devices that access the subject PLM system 10 or selected features thereof may respectively include one or more communication interfaces, one or more memory/media devices, and one or more processing devices such as a microprocessor or the like. Such computing/processing device(s) thus may be adapted to operate as a special-purpose machine by executing the software instructions rendered as part of PLM system 10. The software instructions stored in memory/media device 26 may also define a plurality of different interfaces for accessing the PLM system 10, thus interfacing the PLM system 10 for different corporate entities associated with product management. For example, FIG. 1 illustrates exemplary software interfaces in the form of new product introduction (NPI) interface 312, requisition application interface 314, commission implementation interface 316 and operational feedback interface 318. In this way, different types of access to PLM system 10 can be customized for different corporate entities based on different needs of a product lifecycle (e.g., product creation, requisition, implementation and operation).

System users may be provided with access to the PLM system 10 and/or selected software features thereof via one or more user I/O control devices 320 as also shown in FIG. 1. Exemplary input device(s) may include but are not limited to a keyboard, touch-screen monitor, eye tracker, microphone, mouse and the like. Exemplary output devices may include but are not limited to monitors, printers or other devices for visually depicting output data created in accordance with the disclosed technology. Other I/O devices correspond to intermediate computer components such as memories or processors accessing PLM system 10. The term "user" as used herein refers to a human operator, another computer, or a combination human-computer operator. It should be understood, therefore, that the term "user" is not limited to meaning a human operator.

The particular types of products that may be managed in accordance with the disclosed technology may correspond to a variety of different types of products, assemblies, processes or even computer software. In some particular examples, the disclosed technology may be used with a PLM system for managing aircraft or aerospace components, such as but not limited to gas turbine engines, fans, blades (rotor or stationary), fuselage components, or other components.

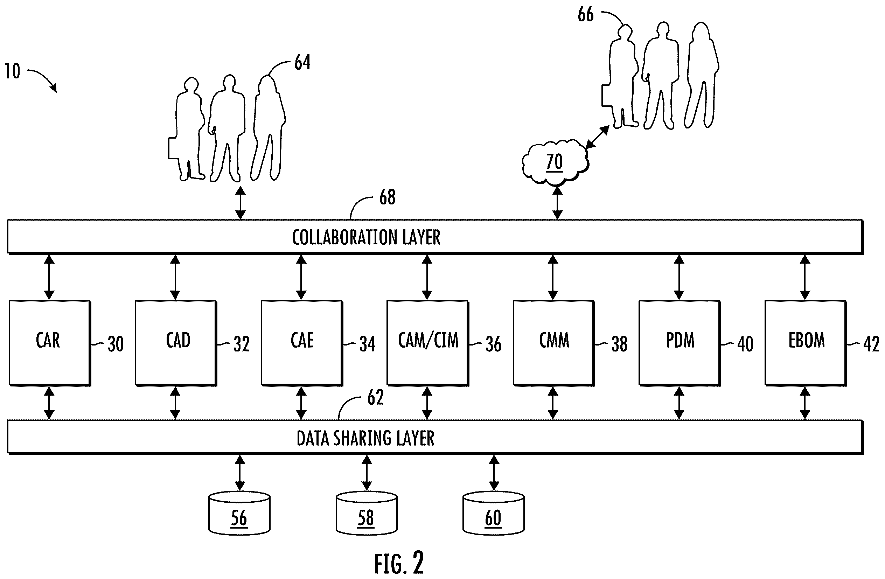

Referring now to FIG. 2, a block diagram of a PLM system 10, which includes a number of PLM based systems or modules (e.g., software systems). More specifically, the PLM system 10 embodiment illustrates a computer-aided requirements capture (CAR) system 30, a computer-aided design (CAD) system 32, a computer-aided engineering (CAE) system 34, computer-aided manufacturing/computer-integrated manufacturing (CAM/CIM) system 36, a coordinate-measuring machine (CMM) system 38, a product data management (PDM) system 40, and an engineering bill of materials (EBOM) system 42. Each of the systems 30, 32, 34, 36, 38, 40, and 42 may be stored in a memory system, such as memory 26 (FIG. 1), and may be executable via a processor, such as via processors 24 (FIG. 1).

In the depicted embodiment, the CAR system 30 may provide for entry of requirements and/or specifications, such as dimensions for the part or product, operational conditions that the part or product is expected to encounter (e.g., temperatures, pressures), certifications to be adhered to, quality control requirements, performance requirements, and so on. For example, in implementations where the product being managed by the PLM system is an aerospace product (such as a turbine blade assembly), the requirements and/or specifications may include structural strength (e.g., turbine blade assembly must withstand loads up to a certain threshold), aerodynamic requirements (e.g., the airfoil of the turbine blade assembly must have a drag coefficient within a certain range), weight constraints, or other requirements. The CAD system 32 may provide for a graphical user interface suitable to create and manipulate graphical representations of 2D and/or 3D models as described above with respect to the design processes 14. For example, the 3D design models may include solid/surface modeling, parametric models, wireframe models, vector models, non-uniform rational basis spline (NURBS) models, geometric models, and the like. The CAD system 32 may provide for the creation and update of the 2D and/or 3D models and related information (e.g., views, drawings, annotations, notes, PMI object, etc.). Indeed, the CAD system 32 may combine a graphical representation of the part or product with other, related information.

The CAE system 34 may enable creation of various engineering models, such as the models described above with respect to the development/engineering processes 16. For example, the CAE system 34 may apply engineering principles to create models such as thermodynamic models, low cycle fatigue (LCF) life prediction models, multibody dynamics (MBD) and kinematics models, computational fluid dynamics (CFD) models, finite element analysis (FEA) models, and/or 3-dimension to 2-dimension FEA mapping models. The CAE system 34 may then apply the aforementioned models to analyze certain part or product properties (e.g., physical properties, thermodynamic properties, fluid flow properties, and so on), for example, to better match the requirements and specifications for the part or product. The CAE system 34 may extract information (e.g., material information, structural information, etc.) from the EBOM or CAD model for simulations, such as FEA simulations CFD simulations, thermal simulations, etc. The CAE system 34 may detect whether the CAD model meets the requirements and may inform whether the CAD model requires adjustment, which then impacts the EBOM, MBOM, and BOP. For example, in implementations where the product being managed by the PLM system is an aerospace product (such as a turbine blade assembly), the CAD model of the turbine blade assembly may be utilized by the CAE system 34 to apply FEA simulations, CFD simulations, or other virtual testing to verify whether the turbine blade assembly meets design requirements (e.g., the CAE system 34 may determine if the airfoil of the turbine blade assembly can withstand certain loads by applying the FEA simulation). If not, the CAD model of the turbine blade assembly may be updated (e.g., the material of the airfoil may be changed or modified).

The CAM/CIM system 36 may provide for certain automation and manufacturing efficiencies, for example, by deriving certain programs or code (e.g., G-code) and then executing the programs or code to manufacture the part or product. The CAM/CIM system 36 may support certain automated manufacturing techniques, such as additive (or subtractive) manufacturing techniques, including material jetting, binder jetting, vat photopolymerization, powder bed fusion, sheet lamination, directed energy deposition, material extrusion, milling, lathing, plasma cutting, wire cutting, or a combination thereof. For example, for an aerospace product (such as a turbine blade assembly), the CAM/CIM system 36 may derive the necessary tool paths for machining the complex shape of the airfoil using a subtractive manufacturing technique (such as milling, turning, grinding, etc.) at least partially based on the CAD model of the aerospace product. Additionally, or alternatively, the CAM/CIM system 36 may generate the layer-by-layer deposition paths to be followed by an additive manufacturing system in order to fabricate the aerospace product at least partially based on the CAD model of the aerospace product. The CMM system 38 may include machinery to automate inspections. For example, probe-based, camera-based, and/or sensor-based machinery may automatically inspect the part or product to ensure compliance with certain geometries, tolerances, shapes, and so on.

The PDM system 40 may be responsible for the management and publication of data from the systems 30, 32, 34, 36, 38, and/or 42. For example, the systems 30, 32, 34, 36, 38, and/or 42 may communicate with data repositories 56, 58, 60 via a data sharing layer 62. The PDM system 40 may then manage collaboration between the systems 30, 32, 34, 36, 38, and/or 42 by providing for data translation services, versioning support, archive management, notices of updates, and so on. The PDM system 40 may additionally provide business support such as interfacing with supplier/vendor systems and/or logistics systems for purchasing, invoicing, order tracking, and so on. The PDM system 40 may also interface with service/logging systems (e.g., service center data management systems) to aid in tracking the maintenance and life cycle of the part or product as it undergoes operations. Teams 64, 66 may collaborate with team members via a collaboration layer 68. The collaboration layer may include web interfaces, messaging systems, file drop/pickup systems, and the like, suitable for sharing information and a variety of data. In implementations where the product being managed by the PLM system 10 is an aerospace product (such as a turbine blade assembly), the collaboration layer 68 may allow for an engineering team to collaborate with a manufacturing team to verify data on the various bill of materials. For example, once the EBOM is generated for the aerospace product, the manufacturing team may collaborate with the engineering team to generate or verify details on the MBOM. Additionally, the collaboration layer 68 may allow for various teams to collaborate in order to achieve collaborative tasks. For example, the engineering team may collaborate with the engineering team to ensure that machining tolerances are achievable for the airfoil of the turbine blade assembly. The collaboration layer 68 may also include cloud-based systems 70 or communicate with the cloud-based systems 70 that may provide for decentralized computing services and file storage. For example, portions (or all) of the systems 30, 32, 34, 36, 38, 42 may be stored in the cloud 70 and/or accessible via the cloud 70.

The EBOM system 42 may generate, manage, and maintain EBOMs associated with assemblies and/or parts generated within the PLM system 10. As should be appreciated, an EBOM is a comprehensive list or table that details all the components (or parts), assemblies, and subassemblies required to produce a product. The EBOM may include specification data, part identification (ID) data, part description data, part quantity data, unit of measurement data, hierarchy data. The other systems of the PLM system 10, such as the CAR system 30, the CAD system 32, the CAE system 34, CAM/CIM system 36, and/or the CMM system 38 may provide data on an assembly, subassembly, component, and/or part produced or managed within the PLM system 10 to the EBOM system 42 for generation and/or management of an EBOM for the assembly, subassembly, component, and/or part.

By enabling the processes 12, 14, 16, 18, 20, and 22 (FIG. 1), for example, via the systems 30, 32, 34, 36, 38, 40, and 42, the techniques described herein may provide for a more efficient "cradle-to-grave" product lifecycle management. For example, as described below in more detail, the processes 12, 14, 16, 18, 20, and 22 (FIG. 1) and the systems 30, 32, 34, 36, 38, 40, 42 may facilitate generation and revision management of a live EBOM using the PLM system 10. The live EBOM may be a single, continuous, bill of materials that includes all historical data and current data for a product from the PLM system. For example, when a revision (or change) is made to one or more parts in the product using the PLM system, the live EBOM may be updated to include the change while maintaining the historical data. This advantageously prevents the creation of a new EBOM every time a revision is made, which drastically reduces data production and thereby reduces data storage costs. Additionally, the live EBOM allows for all changes to the product to be viewed on a single EBOM. The live EBOM may be subsequently utilized for generating the MBOM and/or the BOP.

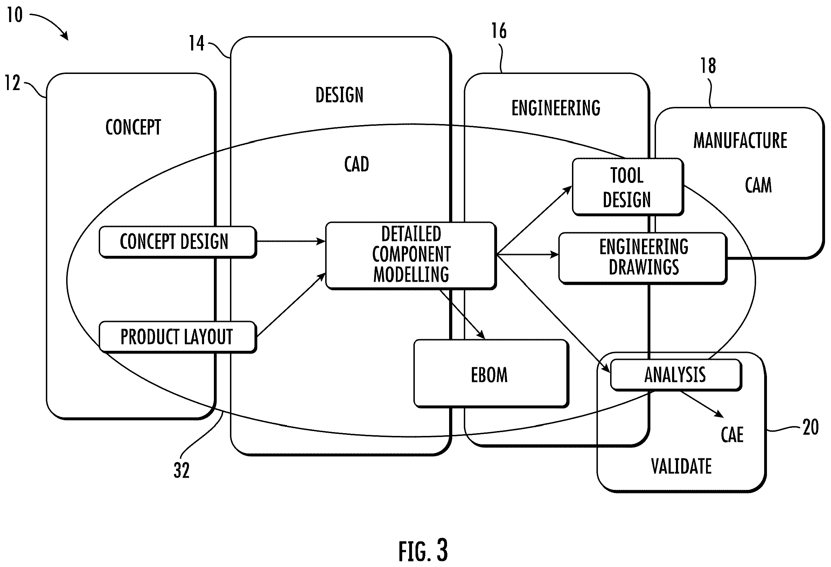

Referring now to FIG. 3, a schematic diagram of a PLM system 10 is illustrated in accordance with embodiments of the present disclosure. Particularly, FIG. 3 shows the logical relationships between the various processes by illustrating how the processes in the PLM system 10 overlap with one another (e.g., in a Venn diagram). As shown, the PLM system 10 is suitable for providing for a variety of processes, including the conception process 12, the design process 14, the engineering process 16, the manufacturing process 18, and the verification/validation process 20, which are described above in detail with reference to FIG. 1. Additionally, the PLM system 10 may be equipped with the CAD system 32, which may be utilized for implementing the PLM processes 12, 14, 16, 18, and 20. The CAD system 32 may provide for a graphical user interface suitable to create and manipulate graphical representations of 2D and/or 3D models as described above with respect to the concept process 12 and the design process 14. For example, the CAD system 32 may provide for detailed component modeling by utilizing the 3D design models, which may include solid/surface modeling, parametric models, wireframe models, vector models, non-uniform rational basis spline (NURBS) models, geometric models, and the like. The CAD system 32 may provide for the creation and update of the 2D and/or 3D models and related information (e.g., views, drawings, annotations, notes, PMI object, etc.). Indeed, the CAD system 32 may combine a graphical representation of the part or product with other, related information.

Additionally, the CAD system 32 may be utilized for generating an assembly model (such as an EBOM) during the design and/or engineering processes 14, 16. Further, the CAD system 32 may be utilized for generating tool design and/or engineering drawings during the engineering and/or manufacturing processes 16, 18. Furthermore, the CAD system 32 may be utilized for analyzing the product during the engineering and/or validation processes 16, 20.

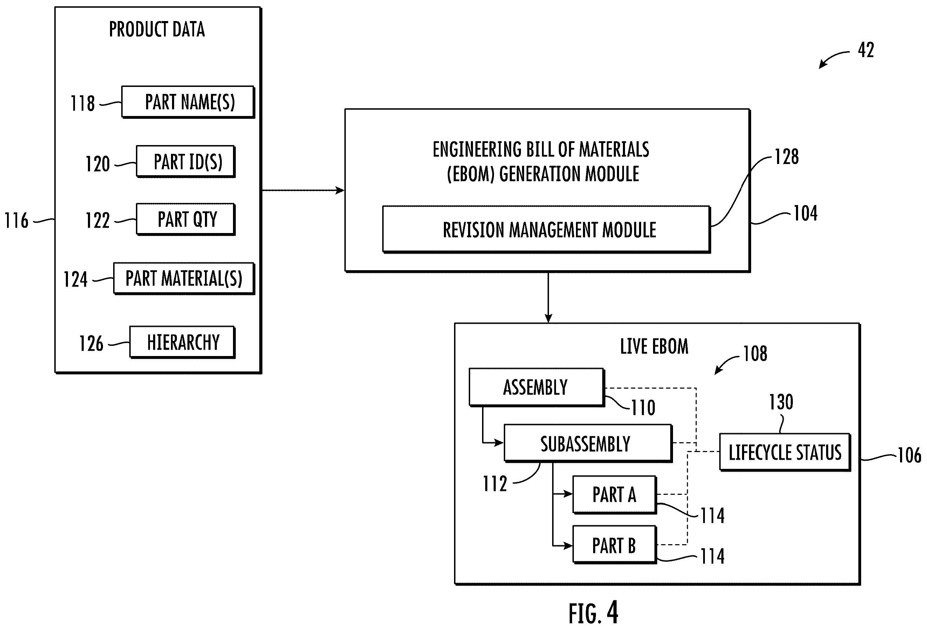

Referring now to FIG. 4, a block diagram of an EBOM system 42, which may be implemented in the PLM system 10 described above with reference to FIGS. 1 and 2, is illustrated in accordance with embodiments of the present disclosure. As shown, the EBOM system 42 may include an EBOM generation module 104. The EBOM generation module 104 may generate, manage, and maintain a live EBOM 106. The live EBOM 106 may be a table 108 or list that includes assemblies 110, subassemblies 112, and parts 114 in a product, such as a product generated with the PLM system 10. For example, in implementations where the product being managed by the PLM system 10 is an aerospace product (such as a turbine blade assembly), the live EBOM 106 may include the part names (e.g., airfoil, root, shroud, etc.) associated with the aerospace component, part numbers (e.g., 1, 2, 3, etc.) associated with each component, part quantities, part materials (e.g., ceramic, titanium, steel, etc.), and other data.

The EBOM generation module 104 may receive or obtain product data 116, e.g., from the PLM system 10, which may be utilized for generating the live EBOM 106. For example, the EBOM generation module 104 may receive product data 116 from one of the systems 30, 32, 34, 36, and/or 38 of the PLM system 10 described above with reference to FIG. 2. Specifically, in exemplary implementations, the product data 116 may be provided by the CAD system 32, the CAE system 34, and/or the CAM/CIM system 36 described above with reference to FIG. 2.

The product data 116 may include part name data 118, part identification (ID) data 120, part quantity data 122, part material data 124, and/or hierarchy data 126. The part name data 118 may include names or descriptions of each assembly, subassembly, and/or part in the product. The part name data 118 may also include a description or descriptor of a material from which the assembly, subassembly, and/or part are formed. Examples of part name data 118 may include "curved handle," "wheel," "aluminum pedal," etc. Part ID data 120 may be a string of characters and/or numbers that are unique to each assembly, subassembly, and part in the product, which enables easy tracking and management of the components. The part quantity data 122 may include the number of each assembly, subassembly, and/or part required to assemble or produce the product. The part material data 124 may be descriptive of the materials used for the parts in the product (e.g., steel, aluminum, plastic, etc.). Hierarchy data 126 may indicate a structured relationship between components of the product, which may be descriptive of which parts are included in an assembly or subassembly and/or which subassembly is included in the assembly. For example, in the live EBOM 106 illustrated in FIG. 4, the parts 114 are included in the subassembly 112, and the subassembly is included in the assembly 110 as indicated by the structured relationship between the components (e.g., the top to bottom and indentation arrangement). For example, if the product is an aerospace product, such as a turbine section, then the assembly 110 may be the rotor assembly, which may include one or more turbine blade subassemblies, which may include an airfoil, a root, a shroud, etc. That is, the indentation arrangement may indicate that the turbine section includes a rotor assembly having a turbine blade subassembly, which includes several parts (such as the airfoil, the root, the shroud, etc.).

In exemplary embodiments, the EBOM generation module 104 may include a revision management module 128. The revision management module 128 may monitor the products within the PLM system 10, and when the product is modified, the revision management module 128 may update the live EBOM 106. For example, if a change is made to a geometry, material, or design of the CAD model associated with the product in the PLM system 10 (for example, the airfoil of the turbine blade assembly), then this may impact how the aerospace product (e.g., the turbine blade assembly) is represented on the EBOM (e.g., in the form of material updates, structure updates, part name updates, part number updates, or others). The revision management module 128 may identify that a change has been made to the CAD model and update the live EBOM 106 accordingly. Specifically, if the material of one or more components (such as an airfoil) of the aerospace product is changed (e.g., from titanium to steel) in the CAD model, then the revision management module 104 may detect or identify the change and update the live EBOM to reflect the change.

In many implementations, the revision management module 128 may generate a lifecycle status 130 for each assembly, subassembly, and/or part in the live EBOM 106. The live EBOM 106 may be generated (or updated), with the EBOM generation module 104, based on the product data and the lifecycle status. Stated otherwise, the live EBOM 106 may include the lifecycle status 130 for each assembly 110, subassembly 112, and part 114. The lifecycle status 130 may be descriptive of whether the assembly 110, subassembly 112, and/or part 114 of the product is in an original form, whether the assembly 110, subassembly 112, and/or part 114 of the product has been active or historical in the current EBOM or not. For example, the lifecycle status 130 may be descriptive of whether the assembly 110, subassembly 112, and/or part 114 of the product is in an original form, whether the assembly 110, subassembly 112, and/or part 114 of the product has been modified during one or more revisions (e.g., from a first version to a second version), or whether the assembly 110, subassembly 112, and/or part 114 of the product is currently being revised. For example, if the product is a turbine rotor blade, then the lifecycle status 130 may indicate whether the turbine rotor blade (e.g., the CAD model representing the turbine rotor blade) is in an originally designed form, whether the turbine rotor blade has been modified during one or more revisions (whether the design, material, quantity, name, or other data associated with the turbine rotor blade has been modified by an engineering team or other user with CAD system), or whether the turbine rotor blade is currently being revised (e.g., whether the engineering team or another user of the PLM system 10 is currently revising the design of the turbine rotor blade with the CAD system). Specifically, in one non-limiting example, if the engineering team or other user modifies the material of the turbine rotor blade by updating the CAD model representing the turbine rotor blade, then the live EBOM 108 may update the lifecycle status 130 to indicate that a change has been made.

The live EBOM 106 may be a single, continuous, bill of materials that includes all historical data and current data on a product from the PLM system 10. For example, when a revision (or change) is made to one or more parts in the product using the PLM system 10, the live EBOM 106 may be updated to include the change while maintaining the historical data. This advantageously prevents the creation of a new EBOM every time a revision is made, which drastically reduces data production and thereby reduces data storage costs. Additionally, the live EBOM 106 allows for all changes to the product to be viewed on a single EBOM. Additionally, the live EBOM 106 may advantageously reduce complexity of generating the MBOM and the BOP. For example, as discussed above, the MBOM and the BOP may include specific instructions for building or manufacturing the product. The live EBOM 106 may prevent a user or machine from having to process several EBOMs to generate the MBOM or BOP. Further, the live EBOM 106 may be provided the CAM/CIM system 36 (FIG. 2), which may derive the machine paths based on the live EBOM 106 that may be provided to a manufacturing device for fabricating the various components of the product. For example, the CAM/CIM system 36 may derive the paths for machining the complex shape of one or more components of the product using a subtractive manufacturing technique (such as milling, turning, grinding, etc.) at least partially based on the CAD model and/or the live EBOM 106, which may be provided to a subtractive manufacturing machine. Additionally, or alternatively, the CAM/CIM system 36 may generate the layer-by-layer deposition paths based on the CAD model and/or the live EBOM 106, which may be provided to an additive manufacturing system in order to fabricate the product.

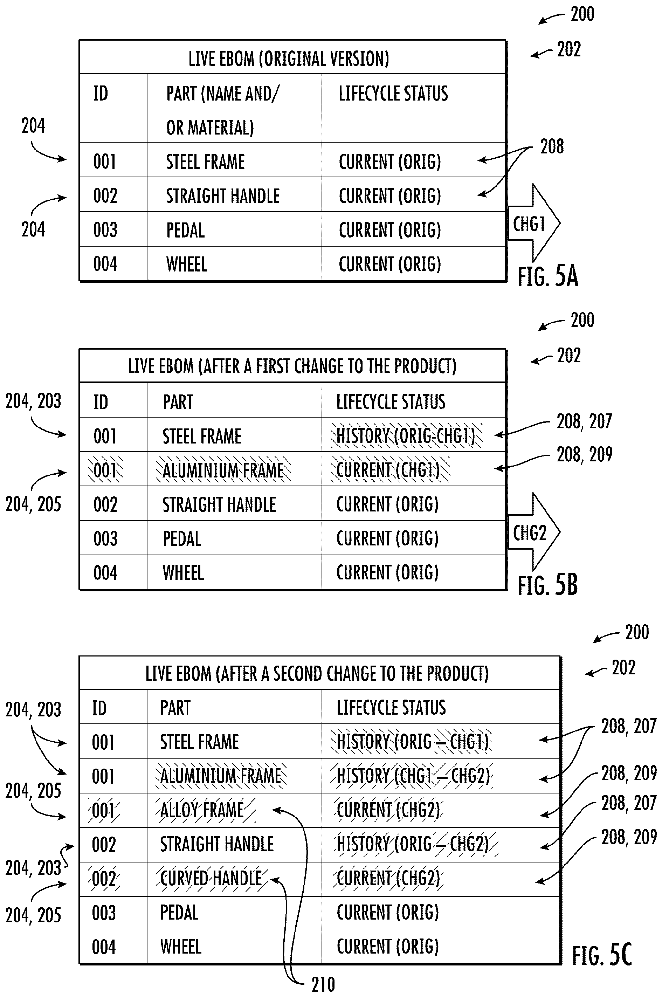

Referring now to FIGS. 5A, 5B, and 5C, a live EBOM 200 is illustrated in accordance with embodiments of the present disclosure. Specifically, FIG. 5A illustrates the live EBOM 200 in representing the product in an original version. FIG. 5B illustrates the live EBOM 200 after a first change (or revision in a traditional system) to one or more parts of the product, resulting in a first version of the product. FIG. 5C illustrates the live EBOM 200 after a second change (or revision in a traditional system) to one or more parts of the product, resulting in a second version of the product.

As shown in FIGS. 5A-5C, the live EBOM 200 includes a table 202 having at least one line 204 (e.g., row) for each part in the product. For example, the live EBOM 200 may list all the parts of the product, which may be generated and managed with the PLM system 10 described above with reference to FIGS. 1 and 2. The table 202 may include at least one line 204 representing each part (or component) of the product, such that each part is listed in the table 202 at least once. In the embodiment shown, the live EBOM 200 may include at least one row and at least one column. For example, data in the live EBOM 200 may be arranged such that each row represents a unique entry associated with a part of the product, and each column categorizes specific attributes or types of data related to that part of the product with respect to the Engineering Bill of Materials. For example, as shown, each row (or line) corresponds to a different part of the product, and each column represents a different type of data related to the part, e.g., part ID data, part name data, and/or lifecycle status 208. While not shown, the live EBOM 200 may include additional columns for other types of data, such as the part quantity data, part material data, and/or hierarchy data described above with reference to FIG. 4. As should be appreciated, in other embodiments (not shown) the arrangement of the live EBOM 200 may be flipped, such that the columns represent a part of the product, and the rows represent an attribute or type of data.

As shown, the lifecycle status 208 for each part identifies whether the line representing the part is historical, current, or in-process (e.g., with a label such as "historical," "current," or "in-process"). Additionally, the lifecycle status 208 for each part identifies at least one of: a part version (e.g., original version, first version, second version) and a version transition. The version transition may indicate or describe "from" and "to" what version a part was modified. For example, if a part is modified from the original version to a first version by Chg1, the lifecycle status 208 may identify this by "Orig-Chg1" indicating that the lines was made historical based on Chg1 or with another similar identifier. In other words, the lifecycle status 208 may be descriptive of at least one of: whether the line (e.g., row) representing the part is historical, current, or in progress; a part version (e.g., original version); and whether the part has been modified between versions during a revision.

For example, as shown in FIG. 5A, which is the live EBOM 200 prior to any modifications to the parts in the product, the lifecycle status 208 for each part indicates that the part is: (1) current (i.e., the most recent and up to date version of the part); and (2) original (i.e., that this is the first or initial version of the part). In this way, the lifecycle status 208 may be indicative or descriptive of both (1) whether the row (e.g., the part described by the row) includes current or historical data; and (2) whether the row is original or has been modified. For example, in the embodiment shown, the lifecycle status 208 of the live EBOM 200 in FIG. 5(A) for each part is "Current (Orig)."

FIG. 5B illustrates the live EBOM 200 after a first change (or revision in a traditional system) has been made to one or more parts of the product. For example, one or more parts of the product may be modified by the PLM system 10 during a new revision period (e.g., a new revision time period). That is, the one or more parts of the product may be modified during the new revision period with at least one of CAR system 30, the CAD system 32, the CAE system 34, the CAM/CIM system 36, and/or the CMM system 38 described above with reference to FIG. 2.

The part quantity, the part name, the part material, part specifications (e.g., size and/or shape), the part hierarchy, or other attributes of the part may be modified by the PLM system 10 to create modified part data 210. In response, the system may generate a current lifecycle status 209 and a historical lifecycle status 207 for the part of the one or more parts that was (or is being) modified, e.g., with the EBOM generation module 104 and/or the revision management module 128 described above with reference to FIG. 4.

Subsequently, or simultaneously, the live EBOM 200 may be updated to reflect the change while maintaining all historical data. That is, for each part that is modified, the EBOM generation module 42 may generate or add a new line 205 (or row) for the modified part that includes the modified data 210, the current lifecycle status 209, and any data that was not changed (e.g., the part ID). In other words, after (or during) the modification of the product with the PLM system 10, the live EBOM 200 may be updated by adding the new line 205 in the table 202 corresponding to the part that was (or is being) modified to create the history line 203 and a current line 205. The current line 205 includes the current lifecycle status 209, the modified data 210, and at least one of the part name data, the part ID data, the part quantity data, and the material data of the part of the one or more parts in the product. The historical line 207 includes the historical lifecycle status 207, and at least one of the part name data, the part ID data, the part quantity data, and the part material data of the part of the one or more parts in the product. The historical line 203 does not include the modified data. This enables each part in the products entire engineering production cycle (e.g., from original version to final version, including all intermediate versions) to be viewed on the single, continuous, live EBOM 200.

For example, when one or more changes, updates, or revisions is made to the part(s) of the product, e.g., using the PLM system 10. The EBOM system 42 may identify what data has been changed for each part in the product, e.g., system may identify whether the part name data 118, the part quantity data122, the part material data 124, and/or the part hierarchy data 126 has been changed for each part in the product to generate the modified data 210. Subsequently, for each part that has been modified during the revision, a new line (or row) may be added to the table 202 while maintaining historical part data. The new line 205 may include the modified data 210 and any data that has not been changed.

As a non-limiting example, as shown by comparing FIGS. 5A and 5B, after the live EBOM 200 shown in FIG. 5A is generated, the part name of the first part in the list may be modified from "steel frame" to "aluminum frame." Subsequently, as shown in FIG. 5B, the live EBOM 200 may be updated in response to modifying the part to reflect the change. That is, the live EBOM 200 may be modified by adding a line 204 (e.g., row) in the table corresponding to the part that was (or is being) modified to create the historical line 203 and the current line 205. The current line 205 includes the new lifecycle status, e.g., "current (chg1)", and at least one of the part name data, part ID data, part material data, and part quantity data of the part of the one or more parts in the product. For example, the current line 205 includes the modified data 210, e.g., the new part name (aluminum frame), and any unchanged data relating to the part, such as the part ID data, part quantity data, etc. The new lifecycle status may be descriptive of: (1) that the current row 205 includes current data; and (2) that the current row 205 was generated as a result of a change made during a first revision period (during the first change to the product). For example, as shown, the new lifecycle status in the current row 205 may be "current (chg1)".

Additionally, the lifecycle status 208 of the historical line 203 may be updated (e.g., to the historical lifecycle status 207) to reflect that this line now contains historical data. The historical lifecycle status 207 may be descriptive of: (1) that the historical row 203 includes historical data; (2) from what version of the product the change or revision was made; (3) to what version of the product resulted from the change or revision. For example, as shown, the historical lifecycle status 207 in the historical line 203 is "History (Orig-Chg1)" indicating that this row contains historical data and that the change was made from the original version during the first revision period (e.g., during the first change to the product) to the first version.

FIG. 5C illustrates the live EBOM 200 after second change or revision has been made to one or more parts of the product. For example, one or more parts of the product may be modified by the PLM system 10 during a second new revision period (e.g., a new revision time period). That is, the one or more parts of the product may be modified during the second new revision period with at least one of CAR system 30, the CAD system 32, the CAE system 34, the CAM/CIM system 36, and/or the CMM system 38 described above with reference to FIG. 2.

As shown by comparing FIGS. 5B and 5C, after the live EBOM 200 shown in FIG. 5B is generated, the part name of part 001 in the list may be modified for a second time from "aluminum frame" to "alloy frame." Additionally, part 002 in the list may be modified from "straight handle" to "curved handle." Subsequently, as shown in FIG. 5C, the live EBOM 200 may be updated in response to modifying the part by changing the part specification (size and/or shape) to reflect the change. That is, the live EBOM 200 may be modified by adding two additional lines 204 (e.g., row) in the table corresponding to the part that was (or is being) modified to create historical lines 203 and current line 205. The current line 205 includes the new lifecycle status, e.g., "current (chg2)", and at least one of the part name data, part ID data, and part quantity data, and material data of the part of the one or more parts in the product. For example, the current line 205 includes the modified data 210, e.g., the part name (alloy frame) and/or the new specification data (e.g., curved handle), and any unchanged data relating to the part(s), such as the part ID data, part quantity data, etc. The new lifecycle status may be descriptive of: (1) that the current line 205 includes current data; and (2) that the current line 205 was generated as a result of a change made during a second revision period. For example, as shown, the new lifecycle status in the current row 205 may be "current (chg2)".

The live EBOM 200 described hereinabove may be a single, continuous, bill of materials that includes all historical data and current data for a product from the PLM system. For example, when a revision (or change) is made to one or more parts in the product using the PLM system 10, the live EBOM 200 may be updated to include the change while maintaining the historical data. This advantageously prevents the creation of a new EBOM every time a revision is made, which drastically reduces data production and thereby reduces data storage and maintenance costs. Additionally, the live EBOM allows for all changes to the product to be viewed on a single EBOM.

Additionally, the live EBOM 200 may be utilized for generating the MBOM and/or the BOP. For example, as discussed above, the MBOM and the BOP may include specific instructions for building or manufacturing the product. The live EBOM 200 may prevent a user or machine from having to process several EBOMs to generate the MBOM or BOP. In this way, the MBOM and/or the BOP may be generated based on the single live EBOM 200 rather than several versions of an EBOM. Further, the live EBOM 106 may be provided the CAM/CIM system 36 (FIG. 2), which may derive the machine paths based on the live EBOM 106 that may be provided to a manufacturing device for fabricating the various components of the product. For example, the CAM/CIM system 36 may derive the paths for machining the complex shape of one or more components of the product using a subtractive manufacturing technique (such as milling, turning, grinding, etc.) at least partially based on the CAD model and/or the live EBOM 106, which may be provided to a subtractive manufacturing machine. Additionally, or alternatively, the CAM/CIM system 36 may generate the layer-by-layer deposition paths based on the CAD model and/or the live EBOM 106, which may be provided to an additive manufacturing system in order to fabricate the product.

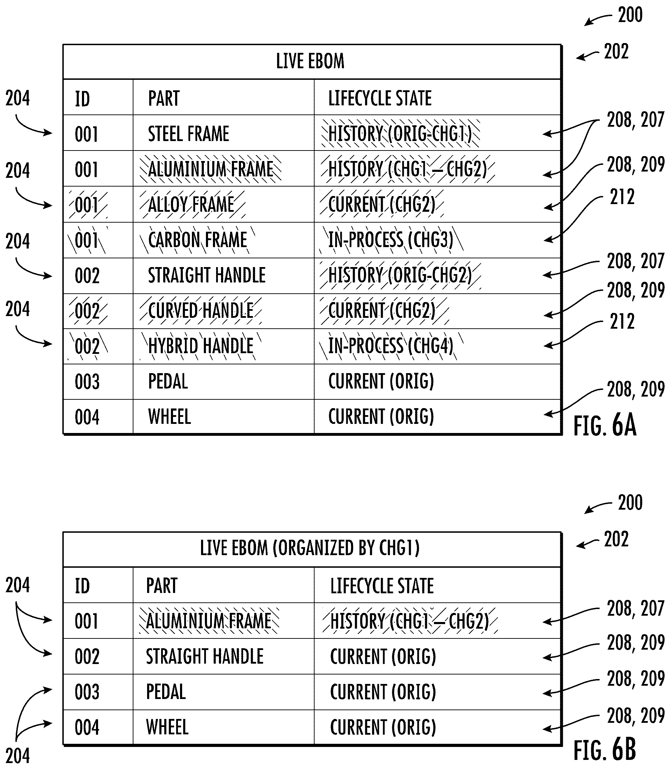

Referring now to FIGS. 6A, 7A, 8A, and 9A, a live EBOM 200 is illustrated in accordance with embodiments of the present disclosure. The live EBOM 200 includes the table 202 having at least one line 204 (e.g., row) representing each part of the one or more parts in the product. For example, the live EBOM 200 may list all the parts of the product, which may be generated and managed with the PLM system 10 described above with reference to FIGS. 1 and 2. Each row (or line 204) corresponds to a different part of the product, and each column represents a different type of data related to the part, e.g., part ID data, part name data, and/or lifecycle status 208.

As shown in FIG. 6A, 7A, 8A, and 9A, the lifecycle status 208 may be a historical lifecycle status 207, a current lifecycle status 209, and/or an in-process lifecycle status 212. Additionally, the lifecycle status 208 for each part identifies at least one of: a part version (e.g., original version, first version, second version) and a version transition. The version transition may indicate or describe "from" and "to" what version a part was modified. For example, with reference to part 001, the lifecycle statuses 208 indicate that this part started as a "steel frame" in the original version. The lifecycle statuses 208 further indicate that part 001 changed to an "aluminum frame" during a first revision, thereby transitioning from the original version to a first version. Subsequently, part 001 was further changed to an "alloy frame" during a second revision, thereby transitioning from the first version to a second version. Lastly, the in-process lifecycle status 212 indicates that part 001 of the product is being further modified during a third revision to a "carbon frame" thereby becoming a third version. Similarly, the lifecycle statuses 208 for part 002 indicate that this part started as a "straight handle," was modified to a "curved handle," and is currently being further modified to a "hybrid handle." This enables each part in the products entire engineering BOM lifecycle (e.g., from original version to final version, including all intermediate versions) to be viewed on the single, continuous, live EBOM 200.

Referring now to FIGS. 6B, 7B, 8B, and 9B, the live EBOM 200 may be organized based on a lifecycle status of interest. Particularly, the lifecycle status 208 is descriptive of both: (a) whether the line representing the part is current, historical, or in-process; and (b) what version of the product the line representing the part belongs to, e.g., original version (Orig), first version (Chg1), second version (Chg2), third version (Chg3), fourth version (Chg4), or any other version. As such, the live EBOM 200 may be organized based on either (a) or (b). That is, the live EBOM 200 may be organized by history or version.

For example, as shown in FIG. 6B, the live EBOM 200 may be organized by the first version of the product. The first version of the product was generated over a first revision period (e.g., time period). As such, the live EBOM 200 may be organized to reflect the product as it existed after the first revision period. In this way, the resulting live EBOM 200 may include any parts modified during the first revision period (e.g., part 001) and any parts that were not modified during the first revision period (e.g., parts 001, 002, and 003). Organizing the table 202 based on the lifecycle status 208 of each part may include selecting one or more lifecycle statuses of interest (e.g., any lifecycle statuses corresponding with the first version of the product), e.g., any lines 204 resulting from the first revision period (e.g., "Orig-Chg1") and any lines 204 not modified during the first revision period (e.g., "Orig"). Subsequently, any lines 204 that do not include the lifecycle statuses of interest may be removed from the table 202, and any lines 204 that include the lifecycle statuses of interest may be maintained. This results in the table 202 shown in FIG. 6B, which illustrates the product as it existed after the first revision period.

The live EBOM 200 may be utilized for generating the MBOM and/or the BOP. For example, as discussed above, live EBOM may define the product as designed, the MBOM may adapt the live EBOM 200 for manufacturing (e.g., by including fabrication/assembly instructions), and the BOP may further adapt the MBOM to include the specific process steps to build the product. By utilizing the live EBOM 200, the PLM system 10 does not have to process several EBOMs to generate the MBOM or BOP. In this way, the MBOM and/or the BOP may be generated based on the single live EBOM 200 rather than several versions of an EBOM. Further, the live EBOM 106 may be provided the CAM/CIM system 36 (FIG. 2), which may derive the machine paths based on the live EBOM 106 that may be provided to a manufacturing device for fabricating the various components of the product. For example, the CAM/CIM system 36 may derive the paths for machining the complex shape of one or more components of the product using a subtractive manufacturing technique (such as milling, turning, grinding, etc.) at least partially based on the CAD model and/or the live EBOM 106, which may be provided to a subtractive manufacturing machine. Additionally, or alternatively, the CAM/CIM system 36 may generate the layer-by-layer deposition paths based on the CAD model and/or the live EBOM 106, which may be provided to an additive manufacturing system in order to fabricate the product.

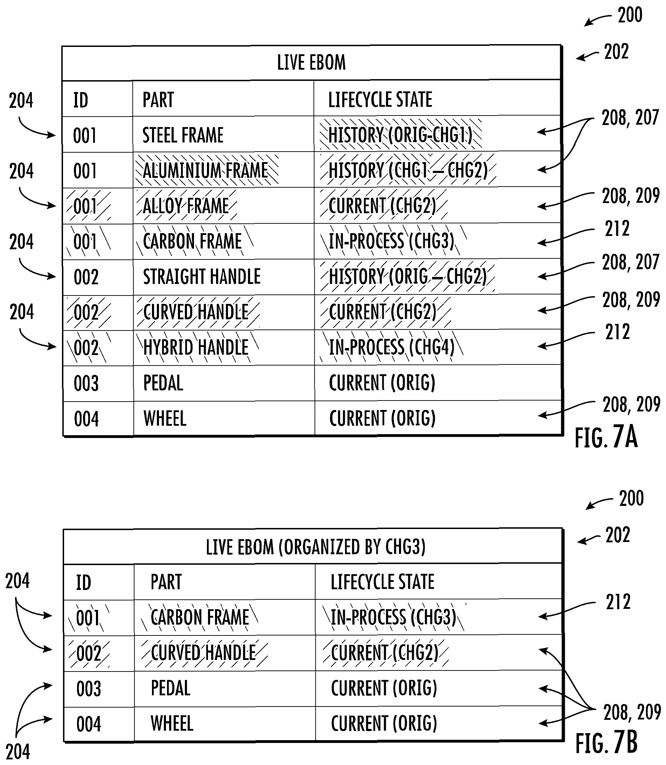

As shown in FIG. 7B, the live EBOM 200 may be organized by the third version (Chg3) of the product. The third version of the product was generated over a first revision period from the original version to the first version, followed by a second revision period from the first version to a second version, followed by a third revision period from the second version to the third version. Not every part in the product may be updated or modified during a revision period. For example, as shown in FIG. 7A, only part 001 is modified during the first revision period from the original version ("Orig") to the first version ("Chg1"), whereas both parts 001 and 002 are modified during the second revision period to the second version ("Chg2").

As such, as shown in FIG. 7B, the live EBOM 200 may be organized to reflect the product as it existed after (or during) the third revision period. In this way, the resulting live EBOM 200 may include any parts modified during the third revision period (e.g., part 001), any parts that were modified prior to the first revision period (e.g., part 002), and any parts that have not been modified from original version (e.g., part 003 and 004). Organizing the table 202 based on the lifecycle status 208 of each part may include selecting one or more lifecycle statuses of interest (e.g., any lifecycle statuses corresponding with the third version of the product). This includes any lines 204 modified during the third revision period, any lines 204 modified prior to the third revision period, and any lines 204 not modified from the original version. Subsequently, any lines 204 that do not include the lifecycle statuses of interest may be removed from the table 202, and any lines 204 that include the lifecycle statuses of interest may be maintained. This results in the table 202 shown in FIG. 7B, which illustrates the product as it existed during the third revision period.

In many embodiments, as shown in FIGS. 6A, 7A, 8A, and 8A, the product may be modified by a plurality of different users at one time, which may be advantageously displayed by the live EBOM 200 simultaneously. For example, as shown, a first user may modify the first part of the product during a third revision period to generate the third version (Chg3) of the product, and a second user may simultaneously modify a second part of the product during a fourth revision period to generate a fourth version (Chg4) of the product. The live EBOM 200 may display both modifications simultaneously, which advantageously allows a user to ascertain all modifications to the product by viewing a single live EBOM 200, rather than several EBOMs.

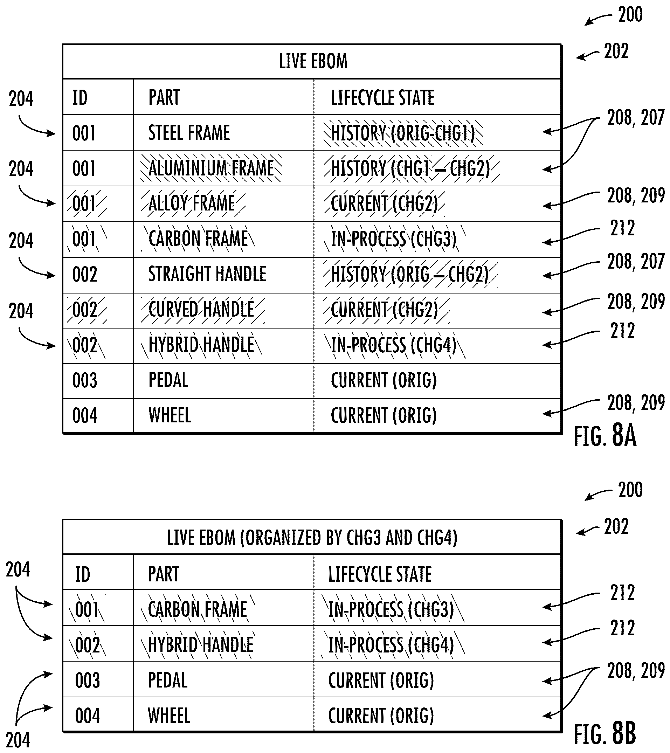

As shown in FIG. 8B, the live EBOM 200 may be organized by the third version (Chg3) and the fourth version (Chg4) of the product. The live EBOM 200 may be organized to reflect the product as it existed after (or during) the third revision period and the fourth revision period. In this way, the resulting live EBOM 200 may include any parts modified during the third revision period (e.g., part 001), any parts modified during the fourth revision period (e.g., part 002), and any parts that have not been modified from original version (e.g., part 003 and 004). Organizing the table 202 based on the lifecycle status 208 of each part may include selecting one or more lifecycle statuses of interest (e.g., any lifecycle statuses corresponding with the third version and the fourth version of the product). This includes any lines 204 modified during the third revision period or the fourth revision period, any lines 204 modified prior to the third revision period and the fourth revision period, and any lines 204 that have not been modified from the original version. Subsequently, any lines 204 that do not include the lifecycle statuses of interest may be removed from the table 202, and any lines 204 that include the lifecycle statuses of interest may be maintained. This results in the table 202 shown in FIG. 8B, which illustrates the product as it existed during the third revision period and the fourth revision period.

Organizing the live EBOM 200 based on version may allow for traceability throughout a product's lifecycle. For example, each version may capture certain design updates and/or material changes to the product. That is, the lifecycle status enables the live EBOM 200 to be organized based on version, which enables the users of the PLM system 10 have access to the EBOM representing most recent design of the product while maintaining the ability to access previous versions for comparison without having to store each version of the EBOM separately. The live EBOM 200 also prevents outdated EBOMs (e.g., a prior version) from being mistakenly utilized for generation of an MBOM or BOP.

As shown in FIG. 9A, the live EBOM 200 may be organized based on whether the lifecycle status is current, historical, or in-process. Particularly, the live EBOM 200 may be organized to reflect the current state of the product (e.g., any revisions that have been finalized and are not in process). In this way, the resulting live EBOM 200 may include the lines 204 including the lifecycle status indicating that the entry is current. Organizing the table 202 based on the lifecycle status 208 of each part may include selecting one or more lifecycle statuses of interest (e.g., any lifecycle statuses indicating that the line 204 is current). Subsequently, any lines 204 that do not include the lifecycle statuses of interest may be removed from the table 202, and any lines 204 that include the lifecycle statuses of interest may be maintained. This results in the table 202 shown in FIG. 9B, which illustrates the current state of the product.

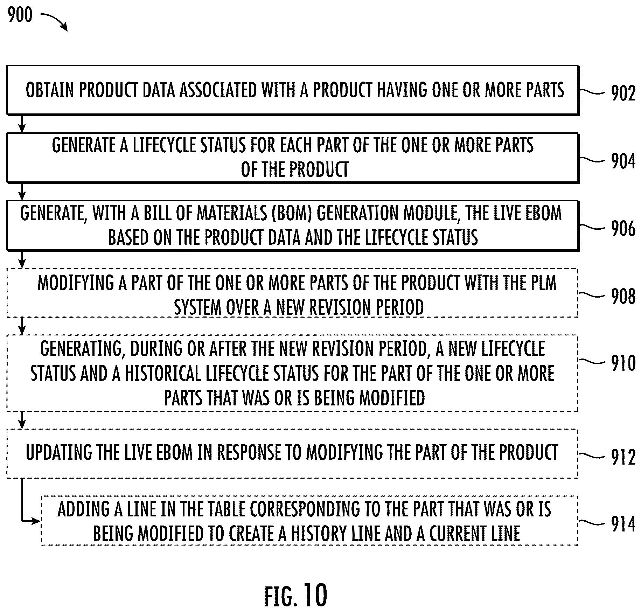

Referring now to FIG. 10, a flow diagram of a method 900 for generating a live EBOM in a PLM system is illustrated in accordance with embodiments of the present subject matter. One or more steps of such methods may be performed by, for example, a computing system 100 as discussed herein. In general, the method 900 will be described herein with reference to the computing system 100, the PLM system 10, the EBOM system 42, and the EBOMs 200 described above with reference to FIGS. 1-9. However, it will be appreciated by those of ordinary skill in the art that the disclosed method 900 may generally be utilized with any other suitable system configuration. In addition, although FIG. 10 depicts steps performed in a particular order for purposes of illustration and discussion, the methods discussed herein are not limited to any particular order or arrangement unless otherwise specified in the claims. One skilled in the art, using the disclosures provided herein, will appreciate that various steps of the methods disclosed herein can be omitted, rearranged, combined, and/or adapted in various ways without deviating from the scope of the present disclosure. Dashed boxes indicate optional steps of the method 900.

For example, the method 900 may include, at (902), obtaining product data associated with a product having one or more parts. The product data includes at least one of part name data, part identification (ID) data, and part quantity data, and material data. The product data may be received by a product data management system of the PLM system. The part name data may include names or descriptions of each assembly, subassembly, and/or part in the product. Part ID data may be a string of characters and/or numbers that are unique to each assembly, subassembly, and part in the product, which enables easy tracking and management of the components. The part quantity data may include the number of each assembly, subassembly, and/or part required to assemble or produce the product. The part material data may be descriptive of the materials used for the parts in the product (e.g., steel, aluminum, plastic, etc.). Hierarchy data may indicate a structured relationship between components of the product, which may be descriptive of which parts are included in an assembly or subassembly and/or which subassembly is included in the assembly.

The method 900 may further include, at (906) generating a lifecycle status for each part of the one or more parts of the product. the lifecycle status 208 for each part identifies whether the line representing the part is historical, current, or in-process (e.g., with a label such as "historical," "current," or "in-process"). Additionally, the lifecycle status 208 for each part identifies at least one of: a part version (e.g., original version, first version, second version) and a version transition. The version transition may indicate or describe "from" and "to" what version a part was modified.

The method 900 may further include, at (906) generating, with a bill of materials (BOM) generation module, the live EBOM based on the product data and the lifecycle status. The live EBOM may be a table having at least one line (or row) representing each part of the one or more parts in the product. Each line of the at least one line includes the lifecycle status and at least one of the part name data, part ID data, part quantity data, and material data.

In some embodiments, the method 900 may further include, at (908), modifying a part of the one or more parts of the product with the PLM system over a new revision period. As a result, at least a portion of the product data is modified as a result of modifying the part to create modified part data. That is, the one or more parts of the product may be modified during the new revision period with at least one of CAR system 30, the CAD system 32, the CAE system 34, the CAM/CIM system 36, and/or the CMM system 38 described above with reference to FIG. 2. The part quantity, the part name, the part material, part specifications (e.g., size and/or shape), the part hierarchy, or other attributes of the part may be modified by the PLM system 10 to create modified part data.

In various embodiments, the method 900 may include, at (910), generating, during or after the new revision period, a new lifecycle status and a historical lifecycle status for the part of the one or more parts that was or is being modified. Subsequently, the method 900 may include, at (912), updating the live EBOM in response to modifying the part. Updating the EBOM at (912) may further include, at (914), adding a line in the table corresponding to the part that was or is being modified to create a history line and a current line. The current line includes the new lifecycle status, the modified data, and at least one of the part name data, the part ID data, and the part quantity data, and the material data of the part of the one or more parts in the product. The historical line includes the historical lifecycle status, and at least one of the part name data, the part ID data, and the part quantity data, and the part material data of the part of the one or more parts in the product.

In some embodiments, modifying at (908) may include modifying the part of the one or more parts of the product with the PLM system over the new revision period from a first version to a second version. In such embodiments, historical lifecycle status is descriptive of that the part was modified from the first version to the second version. In other embodiments, modifying at (908) may include modifying at least one of the part name data to generate modified part name data and the part quantity data to generate modified part quantity data of the part in the product. In such embodiments, the current line includes at least one of the modified part name data and the modified part quantity data, and the historical line includes the (unchanged) part name data and the (unchanged) part quantity data.

In many embodiments, during the new revision period, the method may include generating the new lifecycle status for the part of the one or more parts being modified as descriptive of the part being in a process of modification. For example, while the one or more parts are being modified, the lifecycle status may reflect this on the live EBOM, e.g., with a tag "in-process" or other similar tag. By contrast, after the new revision period, the method may include generating the new lifecycle status for the part of the one or more parts that was modified as descriptive that the part was modified during the new revision period.

In many embodiments, the method may further include organizing the table based on the lifecycle status of each part. Organizing the table may include selecting one or more lifecycle statuses of interest. Based on the selected lifecycle statuses of interest, the method may include removing lines from the table that do not include the one or more lifecycle statuses of interest. Subsequently, or simultaneously, the method may include maintaining lines in the table that include the lifecycle statuses of interest. This results in a table illustrating only lines having the lifecycle statuses of interest.

In many implementations, the method may include generating, at least partially based on the live EBOM, a manufacturing bill of materials (MBOM). The MBOM may be an adapted for manufacturing the product, and the MBOM may be organized for assembly, machining, and production of the product. For example, the MBOM may include manufacturing steps, tooling, work instructions, and/or supplier details in addition to the design details of the product from the live EBOM (including all assemblies, subassemblies, materials, part names, part numbers.

Further, the method may include providing the live EBOM to a computer-aided manufacturing/computer-integrated manufacturing (CAM/CIM) system of the PLM system to derive one or more machine manufacturing models at least partially based on the live EBOM. In such implementations, the method may further include providing the machine manufacturing models to a manufacturing machine to fabricate one or more parts of the product. Stated otherwise, the method may include providing the live EBOM to the CAM/CIM system of the PLM system (FIG. 2), which may derive the machine paths based on the live EBOM that may be provided to a manufacturing device for fabricating the various components of the product. For example, the CAM/CIM system may derive the paths for machining the complex shape of one or more components of the product using a subtractive manufacturing technique (such as milling, turning, grinding, etc.) at least partially based on the CAD model and/or the live EBOM, which may be provided to a subtractive manufacturing machine to fabricate one or more parts of the product. Additionally, or alternatively, the CAM/CIM system may generate the layer-by-layer deposition paths based on the CAD model and/or the live EBOM, which may be provided to an additive manufacturing system in order to fabricate one or more parts of the product.

In various implementations, the method may include displaying, e.g., with one or more display devices (such as a monitor, tablet, etc.), which may be associated with the user I/O control devices 320 described above with reference to FIG. 1, the live EBOM. Alternatively, or additionally, the method may include storing, e.g., in a memory device (such as the memory 26 described above with reference to FIG. 1), the live EBOM.

Traditionally, PLM systems adopt a "revision" based approach when engineering changes impact an EBOM. Every change creates an entirely new EBOM, and the old EBOM is saved as history. The new EBOM typically differs from the old EBOM only in the line items that were impacted by the change that caused the revision. This is not an efficient method because it results in large scale data duplications. For example, traditionally, the old EBOM and the new EBOM are both saved in the PLM system and each include all entries with the only difference being the line items that were impacted by the change. The live EBOM described hereinabove may be a single, continuous, bill of materials that advantageously includes all historical data and current data for a product from the PLM system. For example, when a revision (or change) is made to one or more parts in the product using the PLM system, the live EBOM may be updated to include the change while maintaining the historical data. This advantageously prevents the creation of a new EBOM every time a revision is made, which drastically reduces data production and thereby reduces data storage and maintenance costs. Additionally, the live EBOM allows for all changes to the product to be viewed on a single EBOM.

Further aspects are provided by the subject matter of the following clauses:
A method for generating a live engineering bill of materials (EBOM) in a project lifecycle management (PLM) system, the method comprising: obtaining product data associated with a product having one or more parts, the product data including at least one of part name data, part identification (ID) data, and part quantity data; generating a lifecycle status for each part of the one or more parts of the product; and generating, with a bill of materials (BOM) generation module, the live EBOM based on the product data and the lifecycle status, the live EBOM comprising: a table having at least one line representing each part of the one or more parts in the product, wherein each line of the at least one line includes the lifecycle status and at least one of the part name data, part ID data, and part quantity data.

The method of any preceding clause, further comprising providing the live EBOM to a computer-aided manufacturing/computer-integrated manufacturing (CAM/CIM) system of the PLM system to derive one or more machine manufacturing models at least partially based on the live EBOM; and providing the machine manufacturing models to a manufacturing machine to fabricate one or more parts of the product.

The method of any preceding clause, wherein the lifecycle status for each part identifies whether the line representing the part is historical, current, or in-process.

The method of any preceding clause, wherein the lifecycle status for each part identifies at least one of: a part version; and a version transition.

The method of any preceding clause, further comprising: modifying a part of the one or more parts of the product with the PLM system over a new revision period, whereby at least a portion of the product data is modified as a result of modifying the part to create modified part data; generating, during or after the new revision period, a new lifecycle status and a historical lifecycle status for the part of the one or more parts that was or is being modified; and updating the live EBOM in response to modifying the part of the product by: adding a line in the table corresponding to the part that was or is being modified to create a history line and a current line, the current line including the new lifecycle status, the modified data, and at least one of the part name data, the part ID data, and the part quantity data of the part of the one or more parts in the product, the historical line including the historical lifecycle status, and at least one of the part name data, the part ID data, and the part quantity data of the part of the one or more parts in the product.

The method of any preceding clause, wherein modifying the part comprises: modifying the part of the one or more parts of the product with the PLM system over the new revision period from a first version to a second version, and wherein the historical lifecycle status is descriptive of that the part was modified from the first version to the second version.

The method of any preceding clause, wherein modifying the part of the one or more parts in the product comprises modifying at least one of the part name data to generate modified part name data and the part quantity data to generate modified part quantity data of the part in the product, and wherein the current line includes at least one of the modified part name data and the modified part quantity data.

The method of any preceding clause, wherein during the new revision period, the method comprises: generating the new lifecycle status for the part of the one or more parts being modified as descriptive of the part being in a process of modification.

The method of any preceding clause, wherein after the new revision period, the method comprises: generating the new lifecycle status for the part of the one or more parts that was modified as descriptive that the part was modified during the new revision period.

The method of any preceding clause, further comprising: organizing the table based on the lifecycle status of each part.

The method of any preceding clause, wherein organizing the table comprises: selecting one or more lifecycle statuses of interest; removing lines from the table that do not include the one or more lifecycle statuses of interest; and maintaining lines in the table that include the lifecycle status of interest.

A computing system for generating a live engineering bill of materials (EBOM) in a project lifecycle management (PLM) system, the computing system comprising: one or more processors; and one or more non-transitory computer-readable media that collectively store instructions that, when executed by the one or more processors, cause the computing system to perform operations, the operations comprising: obtaining product data associated with a product having one or more parts, the product data including at least one of part name data, part identification (ID) data, and part quantity data; generating a lifecycle status for each part of the one or more parts of the product; and generating, with a bill of materials (BOM) generation module, the live EBOM based on the product data and the lifecycle status, the live EBOM comprising: a table having at least one line representing each part of the one or more parts in the product, wherein each line of the at least one line includes the lifecycle status and at least one of the part name data, and part ID data, part quantity data.

The system of any preceding clause, wherein the lifecycle status for each part identifies whether the line representing the part is historical, current, or in-process.

The system of any preceding clause, wherein the lifecycle status for each part identifies at least one of: a part version; and a version transition.

The system of any preceding clause, wherein the operations further comprise: modifying a part of the one or more parts of the product with the PLM system over a new revision period, whereby at least a portion of the product data is modified as a result of modifying the part to create modified part data; generating, during or after the new revision period, a new lifecycle status and a historical lifecycle status for the part of the one or more parts that was or is being modified; and updating the live EBOM in response to modifying the part of the product by: adding a line in the table corresponding to the part that was or is being modified to create a history line and a current line, the current line including the new lifecycle status, the modified data, and at least one of the part name data, the part ID data, and the part quantity data of the part of the one or more parts in the product, the historical line including the historical lifecycle status, and at least one of the part name data, the part ID data, and the part quantity data of the part of the one or more parts in the product.

The system of any preceding clause, wherein modifying the part comprises: modifying the part of the one or more parts of the product with the PLM system over the new revision period from a first version to a second version, and wherein the historical lifecycle status is descriptive of that the part was modified from the first version to the second version.

The system of any preceding clause, wherein modifying the part of the one or more parts in the product comprises modifying at least one of the part name data to generate modified part name data and the part quantity data to generate modified part quantity data of the part in the product, and wherein the current line includes at least one of the modified part name data and the modified part quantity data.

The system of any preceding clause, wherein during the new revision period, wherein the operations further comprise: generating the new lifecycle status for the part of the one or more parts being modified as descriptive of the part being in a process of modification.

The system of any preceding clause, wherein after the new revision period, wherein the operations further comprise: generating the new lifecycle status for the part of the one or more parts that was modified as descriptive that the part was modified during the new revision period.

The system of any preceding clause, wherein the operations further comprise: organizing the table based on the lifecycle status of each part.

The system of any preceding clause, wherein organizing the table comprises: selecting one or more lifecycle statuses of interest; removing lines from the table that do not include the one or more lifecycle statuses of interest; and maintaining lines in the table that include the lifecycle status of interest.

This written description uses examples to disclose the present disclosure, including the best mode, and also to enable any person skilled in the art to practice the disclosure, including making and using any devices or systems and performing any incorporated methods. The patentable scope of the disclosure is defined by the claims, and may include other examples that occur to those skilled in the art. Such other examples are intended to be within the scope of the claims if they include structural elements that do not differ from the literal language of the claims, or if they include equivalent structural elements with insubstantial differences from the literal languages of the claims.

## Claims

1. A method for generating a live engineering bill of materials (EBOM) (200) in a project lifecycle management (PLM) system (10), the method comprising:
obtaining product data (116) associated with a product having one or more parts, the product data (116) including at least one of part name data (118), part identification (ID) data (120), or part quantity data (122);
generating a lifecycle status (208) for each part of the one or more parts of the product; and
generating, with a bill of materials (BOM) generation module, the live EBOM (200) based on the product data (116) and the lifecycle status (208), the live EBOM (200) comprising:
a table (202) having at least one line (204) representing each part of the one or more parts in the product, wherein each line (204) of the at least one line (204) includes the lifecycle status (208) and at least one of the part name data (118), part ID data (120), or part quantity data (122).

2. The method of claim 1, wherein the lifecycle status (208) for each part identifies whether the line representing the part is historical, current, or in-process.

3. The method of claim 1, wherein the lifecycle status (208) for each part identifies at least one of: a part version or a version transition.

4. The method of any preceding claim, further comprising:
modifying a part of the one or more parts of the product with the PLM system (10) over a new revision period, whereby at least a portion of the product data (116) is modified as a result of modifying the part to create modified part data (210);
generating, during or after the new revision period, a new lifecycle status (209) and a historical lifecycle status (207) for the part of the one or more parts that was or is being modified; and
updating the live EBOM (200) in response to modifying the part of the product by:
adding a line in the table (202) corresponding to the part that was or is being modified to create a history line (203) and a current line (205), the current line (205) including the new lifecycle status (209), the modified data (210), and at least one of the part name data (118), the part ID data (120), or the part quantity data (122) of the part of the one or more parts in the product, the historical line (203) including the historical lifecycle status (207), and at least one of the part name data (118), the part ID data (120), or the part quantity data (122) of the part of the one or more parts in the product.

5. The method of claim 4, wherein modifying the part comprises:
modifying the part of the one or more parts of the product with the PLM system (10) over the new revision period from a first version to a second version, and wherein the historical lifecycle status (207) is descriptive of that the part was modified from the first version to the second version.

6. The method of claim 4, wherein modifying the part of the one or more parts in the product comprises modifying at least one of the part name data (118) to generate modified part name data or the part quantity data (122) to generate modified part quantity data of the part in the product, and wherein the current line (205) includes at least one of the modified part name data or the modified part quantity data.

7. The method of claim 4, wherein during the new revision period, the method comprises:
generating the new lifecycle status (209) for the part of the one or more parts being modified as descriptive of the part being in a process of modification.

8. The method of claim 4, wherein after the new revision period, the method comprises:
generating the new lifecycle status (209) for the part of the one or more parts that was modified as descriptive that the part was modified during the new revision period.

9. The method of any preceding claim, further comprising:
organizing the table (202) based on the lifecycle status (208) of each part.

10. The method of claim 9, wherein organizing the table (202) comprises:
selecting one or more lifecycle statuses (208) of interest;
removing lines from the table (202) that do not include the one or more lifecycle statuses (208) of interest; and
maintaining lines in the table (202) that include the lifecycle statuses (208) of interest.

11. A computing system for generating a live engineering bill of materials (EBOM) (200) in a project lifecycle management (PLM) system (10), the computing system comprising:
one or more processors (24); and
one or more non-transitory computer-readable media (26) that collectively store instructions that, when executed by the one or more processors (24), cause the computing system to perform operations, the operations comprising:
obtaining product data (116) associated with a product having one or more parts, the product data (116) including at least one of part name data (118), part identification (ID) data (120), or part quantity data (122);
generating a lifecycle status (208) for each part of the one or more parts of the product; and
generating, with a bill of materials (BOM) generation module, the live EBOM (200) based on the product data (116) and the lifecycle status (208), the live EBOM (200) comprising:
a table (202) having at least one line (204) representing each part of the one or more parts in the product, wherein each line (204) of the at least one line (204) includes the lifecycle status (208) and at least one of the part name data (118), part ID data (120), or part quantity data (122).

12. The system of claim 11, wherein the lifecycle status (208) for each part identifies whether the line (204) representing the part is historical, current, or in-process.

13. The system of any of claims 11-12, wherein the lifecycle status (208) for each part identifies at least one of: a part version or a version transition.

14. The system of any of claims 11-13, wherein the operations further comprise:
modifying a part of the one or more parts of the product with the PLM system (10) over a new revision period, whereby at least a portion of the product data (116) is modified as a result of modifying the part to create modified part data (210);
generating, during or after the new revision period, a new lifecycle status (209) historical lifecycle status (207) for the part of the one or more parts that was or is being modified; and
updating the live EBOM (200) in response to modifying the part of the product by:
adding a line in the table (202) corresponding to the part that was or is being modified to create a history line (203) and a current line (205), the current line (205) including the new lifecycle status (209), the modified data (210), and at least one of the part name data (118), the part ID data (120), or the part quantity data (122) of the part of the one or more parts in the product, the historical line including the historical lifecycle status (207), and at least one of the part name data (118), the part ID data (120), or the part quantity data (122) of the part of the one or more parts in the product.

15. The system of claim 14, wherein modifying the part comprises:
modifying the part of the one or more parts of the product with the PLM system (10) over the new revision period from a first version to a second version, and wherein the historical lifecycle status (207) is descriptive of that the part was modified from the first version to the second version.
